# EUROPEAN PATENT APPLICATION

(11) **EP 2 391 186 A1**
(43) Date of publication of application: **30.11.2011**
(21) Application number: 10733504.4
(22) Date of filing: 21.01.2010
(51) Int. Cl.: H05B 33/10, B41M 5/00, C09D 11/00, H01L 51/50

(54) **INK-JET PRINTING INK FOR ORGANIC ELECTROLUMINESCENT ELEMENT, AND PROCESS FOR PRODUCTION OF ORGANIC ELECTROLUMINESCENT ELEMENT**

(30) Priority: 22.01.2009 JP 2009012182
(71) Applicant: Sumitomo Chemical Company, Limited, Tokyo 104-8260 (JP)
(72) Inventor: KAWANISHI, Yutaka, Tsukuba-shi Ibaraki 305-0821 (JP)
(74) Representative: Vossius & Partner
(86) International application number: PCT/JP2010/050670
(87) International publication number: WO 2010/084897

(57) **Abstract**

The problem is to provide such an ink-jet ink for organic EL devices that a jetted droplet trails no ligaments and wet-spreads well upon adhering. The solution is an ink-jet ink for organic electroluminescent device comprising water, a surfactant and an aqueous macromolecular material, wherein the ink has a static surface tension of 40 mN/m or less and a dynamic surface tension, measured by a maximum bubble pressure method at 100 Hz, of 55 mN/m or more.

## Description

### TECHNICAL FIELD

The present invention relates to an ink-jet ink for organic electroluminescent devices and a method for producing an organic electroluminescent device using the ink.

### BACKGROUND ART

Organic electroluminescent devices (hereinafter sometimes referred to as organic EL devices) have a constitution including a pair of electrodes and one or a plurality of organic layers provided between the electrodes. Organic EL devices have at least a light-emitting layer as said organic layer and emit light due to recombination of holes and electrons injected from a pair of electrodes that occurs in a light-emitting layer as a result of voltage application.

From the viewpoint of simpleness of processes, investigations have been made to form an organic layer by the application method. One approach is an ink-jet printing method that comprises jetting an ink containing an organic compound for constituting an organic layer, a solvent and so on, in the form of droplets through a nozzle, and making it adhere prescribed positions (see, for example, Patent Document 1).

An ink-jet ink to be used for the conventional ink-jet printing method has the problem that a droplet of the ink adhered is difficult to wet-spread or that the droplet does not come to have a spherical form when being jetted through a nozzle, so that the droplet trails a tail from the nozzle opening (hereinafter, this may be referred to as trail a ligament).

When a droplet is poor in nature to wet-spread, the ink is difficult to spread to a desired area and, therefore, a film formed by applying the ink easily becomes uneven in thickness. In such a case that a droplet trails a ligament, there occur, for example, deterioration of directionality of the droplet or the phenomenon that while the tip part of the droplet attaches to a desired position, the tail part of the droplet (i.e., ligament part) protrudes out of a prescribed frame. As a result, it will become difficult to apply the ink at high accuracy.

Patent Document 2 discloses a technology of improving wet-spreading property of an ink-jet ink for color filters. This ink is characterized by containing a binder component, a pigment and a solvent and further containing an alkane solvent that is low in surface tension. Because of this characteristic, the viscosity and the surface tension of the ink appropriately decrease, so that the ink itself has an improved wet-spreading property.

Patent Document 3 discloses a technology of improving ink adhesion accuracy of an ink-jet ink for color filters. This ink is characterized by containing a combination of two or more solvents having low evaporation rate and high surface tension. Because of this characteristic, the ink comes to have high surface tension, so that a droplet formed by the ink-jet method will be in an almost spherical shape.

Thus, there are technologies of improving either the wet-spreading property of an ink or the shape of a droplet to be jetted. There, however, are no ink-jet inks that satisfy both the performances, so that a droplet jetted trails no ligaments and the droplet wet-spreads well upon adhering. It is noted that the technologies disclosed in Patent Documents 2 and 3 are technologies about a solvent type ink, and characteristics of an aqueous ink are not disclosed therein.

### BACKGROUND ART DOCUMENTS

### PATENT DOCUMENTS

Patent document 1: Japanese Patent Laid-open Publication No. 10-12377
Patent document 2: Japanese Patent Laid-open Publication No. 2006-284752
Patent document 3: Japanese Patent Laid-open Publication No. 2008-70864

### DISCLOSURE OF THE INVENTION

### PROBLEMS TO BE SOLVED BY THE INVENTION

An objective of the present invention is to provide an aqueous ink-jet ink for organic EL devices such that a jetted droplet trails no ligaments and wet-spreads well upon adhering.

### MEANS FOR SOLVING THE PROBLEMS

That is, the present invention provides an ink-jet ink for organic electroluminescent devices comprising water, a surfactant and an aqueous macromolecular material, wherein the ink has a static surface tension of 40 mN/m or less and a dynamic surface tension, measured by the maximum bubble pressure method at 100 Hz, of 55 mN/m or more.

In one embodiment, the surfactant comprises a linear polyether alcohol.

In one embodiment, the molecular weight of the linear polyether alcohol is 250 to 600.

In one embodiment, the linear polyether alcohol has a structure represented by the formula:

Rₗ-(0-R₂)n-OH [Chem 1]

wherein R₁ is an alkyl group that may have a substituent, R₂ is an alkylene group that may have a substituent, and n is a natural number, provided that when there are two or more R₂s, the R₂s may be the same or different.

In one embodiment, R₁ is a linear alkyl group having 4 to 20 carbon atoms, R₂ is a linear alkylene group having 1 to 10 carbon atoms, and n is an integer of 1 to 12.

In one embodiment, the surfactant is pentaethylene glycol monododecyl ether.

In one embodiment, the content of the surfactant is 0.001 to 10 parts by weight based on 100 parts by weight of the whole amount of the ink-jet ink for organic EL devices.

In one embodiment, the aqueous macromolecular material is an aqueous conductive macromolecule.

Moreover, the present invention provides a method for producing an organic EL device having a pair of electrodes and an organic layer provided between the electrodes, wherein the method for producing an organic EL device comprises a step of forming the organic layer by the ink-jet method using the aforementioned ink-jet ink for organic EL devices.

### EFFECT OF THE INVENTION

With the ink-jet ink for organic EL devices of the present invention, it is possible to make an ink adhere to a desired position at high accuracy because a droplet thereof trails no ligaments. Since a droplet wet-spreads well on the site where it has adhered, the thickness of a film formed by applying ink becomes uniform. Therefore, the ink-jet ink for organic EL devices of the present invention is extremely useful industrially.

### BRIEF DESCRIPTION OF THE DRAWINGS

[Fig. 1] A graph showing dynamic surface tensions of inks 1 to 3.
[Fig. 2] A photograph showing the shape of ink 1 dropping.
[Fig. 3] A photograph showing the shape of ink 2 dropping.
[Fig. 4] A photograph showing the shape of ink 3 dropping.

### EMBODIMENT FOR CARRYING OUT THE INVENTION

### Ink-jet ink for organic EL device

An ink-jet ink for organic EL devices of the present invention is an aqueous ink. The aqueous ink means any ink containing water as a primary component of its solvent. The primary component means a component that accounts for at least about 50% by weight. When the whole amount of the ink-jet ink for organic EL devices is assumed to be 100 parts by weight, the proportion accounted for by water is usually 50 parts by weight to 99.989 parts by weight and preferably 60 parts by weight to 99.9 parts by weight.

Since the static surface tension of the ink-jet ink for organic EL devices of the present invention is as low as 40 mN/m or less, when an ink jetted through a nozzle hits a surface, it easily wet-spreads on the hit surface. If the ink is high in static surface tension, the ink is difficult to wet-spread on a hit surface, and particularly when the ink is dropped to a pixel region surrounded by partitions as described later, the ink is easily repelled on the partitions and, as a result, the peripheral portion which contacts the partitions becomes thin.

On the other hand, the use of an ink low in static surface tension facilitates the ink to wet-spread and can prevent the ink from being repelled on partitions, so that an organic film uniform in thickness can be formed when drying. The static surface tension is a surface tension measured in the state where a liquid to be measured is at rest or approximately at rest, and in the present description, the static surface tension is a value measured by the pendant drop method. An ink-jet ink for organic EL devices of the present invention is preferably 20 to 45 mN/m, more preferably 25 to 40 mN/m in static surface tension.

The dynamic surface tension of the ink-jet ink for organic EL devices of the present invention, expressed by a value measured by the maximum bubble pressure method at 100 Hz, is as high as 55 mN/m or more. For example, in an ink-jet apparatus, an ink is dropped by applying voltage to a piezoelectric element provided in a nozzle and vibrating the piezoelectric element at a prescribed frequency. In such an ink-jet apparatus that drops an ink at a prescribed frequency, the state of the ink at the time of being jetted depends greatly on the dynamic surface tension of the ink.

If the dynamic surface tension of an ink-jet ink for organic EL devices is low, a jetted droplet trails a ligament as described above and, therefore, it will become difficult to make an ink adhere to a desired position at high accuracy when dropping the ink while moving a nozzle. On the other hand, if the generation of ligament is prevented by increasing dynamic surface tension of an ink-jet ink for organic EL devices, it is possible to drop the ink in the form of a spherical droplet and, therefore, it is possible to make the ink hit a desired position at high accuracy.

Although inks small in static surface tension are usually small also in dynamic surface tension, an ink-jet ink for organic EL devices of the present invention can be produced with the relationship between its static surface tension and its dynamic surface tension adjusted to a prescribed value by using a specific surfactant and the like, whereby an organic film uniform in thickness can be formed at a prescribed position. In this description, a dynamic surface tension is a value measured by a maximum bubble pressure method, and a wording simply-written as "dynamic surface tension" means a surface tension at a bubble discharge frequency of 100 Hz. The dynamic surface tension by the maximum bubble pressure method can be measured by using, for example, a dynamic surface tension measurement apparatus "Bubble Pressure Tensiometer MPT2" manufactured by LAUDA. The dynamic surface tension of an ink-jet ink for organic EL devices of the present invention is preferably 50 to 80 mN/m and more preferably 55 to 75 mN/m.

Among such surfactants, for example, nonionic surfactants are preferred and specific examples thereof include polyether alcohols. The molecular form of the nonionic surfactants is preferably a linear form. More preferred examples of the surfactants include polyether monool and polyether diol. The molecular weight of the surfactant is 100 to 800, preferably 200 to 700 and more preferably 250 to 600.

When the molecular weight of the surfactants is less than 100, the value of the dynamic surface tension tends to become small, whereas when it exceeds 800, the difference between the value of the static surface tension and the value of the dynamic surface tension at 100 Hz may be small.

Especially a preferable surfactant is a polyether monool having a structure represented by the formula:

Rₗ-(O-R₂)ₙ-OH [Chem 2]

wherein R₁ is an alkyl group that may have a substituent, R₂ is an alkylene group that may have a substituent, and n is a natural number, provided that when there are two or more R₂s, the R₂s may be the same or different.

The number of carbon atoms of the alkyl group R₁ is preferably 1 to 20 and more preferably 4 to 16. The alkyl group is preferably in a linear form because it is easy to adjust the surface tension of the ink. Examples of the substituent that the alkyl group may have include alkoxy groups. The number of carbon atoms of the alkylene group R₂ is preferably 1 to 10 and more preferably 2 to 6.

n is an integer of 1 to 12, preferably 3 to 10. If n exceeds 12, the dynamic surface tension may fail to become high even if the frequency is increased. A particularly preferred example of the surfactant is pentaethylene glycol monododecyl ether.

When the whole amount of the ink-jet ink for organic EL devices is assumed to be 100 parts by weight, the amount accounted for by the surfactant is usually 0.001 parts by weight to 10 parts by weight and preferably 0.01 parts by weight to 5 parts by weight. When the amount of the surfactant is less than 0.001 parts by weight, no influence may be exhibited on surface tension, whereas when it exceeds 10 parts by weight, the difference between the value of the static surface tension and the value of the dynamic surface tension at 100 Hz may be small.

The surfactant to be used in the present invention preferably has an aqueousity-hydrophobicity parameter (HLB value) of 2 to 25, more preferably 3 to 18. When the HLB value of the surfactant is less than 2 or when it exceeds 25, the surfactant may be present on the pulk side with respect to an interface, failing to exhibit surface activity.

An aqueous macromolecular material means a water-soluble macromolecule or a water-dispersible macromolecule. The aqueous macromolecular material may be a material that can form a hole transporting layer, a hole injection layer, a light-emitting layer, an electron transporting layer, or the like which will be described below. Examples of such an aqueous macromolecular material include aqueous conductive macromolecules. Specifically, polyaniline, polypyrrole, poly(3,4-ethylenedioxythiophene) and poly(4-styrenesulfonic acid) are provided as examples.

As to the aqueous macromolecular material, a mixture (PEDOT/PSS) of poly(3,4-ethylenedioxythiophene) and poly(4-styrenesulfonic acid) is suited as an ink-jet ink to be used for forming an organic film made of PEDOT/PSS because an organic film uniform in thickness can be formed at a prescribed position particularly when it is used as the aqueous macromolecular material.

In this description, an aqueous macromolecular material means a material having a polystyrene-equivalent number average molecular weight of 800 or more, preferably 800 to 1000000 and more preferably 1000 to 500000. When the number average molecular weight of the aqueous macromolecular material exceeds 1000000, a ligament becomes long, and directionality becomes poor when being jetted from an ink-jet apparatus.

When the whole amount of the ink-jet ink for organic EL devices is assumed to be 100 parts by weight, amount accounted for by the aqueous macromolecular material is usually 0.01 parts by weight to 20 parts by weight and preferably 0.1 parts by weight to 10 parts by weight. If the amount of the aqueous macromolecular material is less than 0.01 parts by weight, the thickness of the film formed by application may not become a desired value, whereas if it exceeds 10 parts by weight, the ink may be unsuitable as an ink-jet ink, for example, the viscosity of the ink becomes very high or a ligament is easily trailed.

The ink-jet ink for organic EL devices may contain substances other than water, the surfactant and the aqueous macromolecular material, and it may contain polyhydric alcohols such as glycerin and ethylene glycol, for example.

The static surface tension and the dynamic surface tension of the ink-jet ink for organic EL devices can be adjusted by appropriately selecting the mixing ratio of a composition and the type of the surfactant. Especially, the surface tension can be adjusted by appropriately selecting the type of the surfactant. For example, in the case of adding a surfactant, there is a tendency that the surface tension increases as frequency increases, but when the surfactant to be used is large in molecular weight, the surface tension may not become very high even if the frequency is increased. The use of a surfactant having a prescribed molecular weight can realize an ink-jet ink for organic EL devices that is low in static surface tension and high in dynamic surface tension.

Specifically, in the use of a polyether monool having a structure represented by the formula as the surfactant:

CₐH₂ₐ₊ₗ(OC₂H₄)ₙOH [Chem 3]

wherein a and n each represent a natural number,

the larger the n of the surfactant is, the smaller the increase in surface tension is, even if the bubble discharge frequency is made high. n in the above formula is an integer of 1 to 12, preferably 3 to 10.

An ink-jet ink for organic EL devices of the present invention is produced by mixing proper amounts of the components described above. The order of mixing the components is not particularly limited, and it is just required that uniform mixing will be realized. For example, a surfactant is mixed to a solvent first, then an aqueous macromolecular material is mixed to the mixture, and then other components are mixed to make homogeneous.

### Method for producing organic EL device

Next, a method for producing an organic EL device using an ink-jet ink for organic EL devices is described. An organic EL device has a pair of electrodes and an organic layer provided between the electrodes. In the present invention, this organic layer is formed by the ink-jet printing method using the above-mentioned ink-jet ink for organic EL devices.

An organic EL device is usually disposed on a substrate. For example, in a panel for a display apparatus, an organic EL device is formed in each pixel region surrounded by partitions formed in a lattice-form on the substrate.

Specifically, in an active matrix type display apparatus, anodes are arranged discretely in a matrix form on a substrate, and partitions of a lattice-form viewed in the thickness direction of the substrate are provided so that a surface of each anode may be exposed. The partitions are formed by photolithography using a photosensitive resin. Each region surrounded by the partitions corresponds to a pixel region.

Using a material to form a hole transporting layer, a hole injection layer, a light-emitting layer, an electron transporting layer or the like as the aqueous macromolecular material of the aforementioned ink-jet ink for organic EL devices and using an ink-jet apparatus, an ink-jet ink for organic EL devices is dropped into each pixel region. Next, an organic layer can be formed in each pixel region by drying the solvent by baking or letting it stand. This allows a hole transporting layer, a hole injection layer, a light-emitting layer, an electron transporting layer and the like to be formed so that the thickness thereof may be uniform in each pixel region. By repeating dropping of ink and its drying, a layered body composed of a hole transporting layer, a hole injection layer, a light-emitting layer, an electron transporting layer and the like can be formed. Moreover, by forming a cathode, organic EL devices each of which functions as a pixel can be formed.

An ink-jet ink for organic EL devices of the present invention can be used suitably not only for an active matrix type substrate but also for a passive matrix type substrate, and it can be used suitably also for an organic EL device of such a constitution that the cathode is positioned closer to the substrate than the anode is. Also when forming an organic EL device between the partitions arranged in stripe form, an ink-jet ink for organic EL devices of the present invention can be used suitably.

### General constitution of organic EL device

Next, the constitution of an organic EL device is described in more detail. An organic EL device of the present embodiment has an anode, a cathode and a light-emitting layer arranged between the anode and the cathode as essential constituents, and it may have another layer different from the light-emitting layer between the anode and the light-emitting layer and/or between the light-emitting layer and the cathode. Between the anode and the cathode may be provided not only one light-emitting layer but also two or more light-emitting layers.

Examples of the layer to be provided between the cathode and the light-emitting layer include an electron injection layer, an electron transporting layer and a hole blocking layer. When only one layer is provided between the cathode and the light-emitting layer, this layer is referred to as an electron injection layer. When both the electron injection layer and the electron transporting layer are provided between the cathode and the light-emitting layer, the layer that is in contact with the cathode is referred to as an electron injection layer, and the layer excluding this electron injection layer is referred to as an electron transporting layer.

The electron injection layer is a layer that has the function to improve electron injection efficiency from the cathode. The electron transporting layer is a layer that has the function to improve electron injection from the cathode, the electron injection layer or an electron transporting layer that is closer to the cathode. The hole blocking layer is a layer that has a function to interrupt transportation of holes. When the electron injection layer and/or the electron transporting layer has a function to interrupt transportation of holes, these layers may also serve as a hole blocking layer.

That a hole blocking layer has a function to interrupt transportation of holes can be confirmed by producing a device that allows only hole current to pass and detecting decrease in current value of the device.

Examples of the layer to be provided between the anode and the light-emitting layer include a hole injection layer, a hole transporting layer and an electron blocking layer. When only one layer is provided between the anode and the light-emitting layer, this layer is referred to as a hole injection layer. When both the hole injection layer and the hole transporting layer are provided between the anode and the light-emitting layer, the layer that is in contact with anode is referred to as a hole injection layer and the layer excluding this hole injection layer is referred to as a hole transporting layer.

The hole injection layer is a layer that has the function to improve hole injection efficiency from the anode. The hole transporting layer is a layer that has the function to improve hole injection from the anode, the hole injection layer or a hole transporting layer that is closer to the anode. The electron blocking layer is a layer that has a function to interrupt transportation of electrons. When the hole injection layer and/or the hole transporting layer has a function to interrupt transportation of electrons, these layers may also serve as an electron blocking layer.

That an electron blocking layer has a function to interrupt transportation of electrons can be confirmed by producing a device that allows only electron current to pass and detecting decrease in current value of the device.

An electron injection layer and a hole injection layer may be collectively referred to as a charge injection layer, whereas an electron transporting layer and a hole transporting layer may be collectively referred to as a charge transporting layer.

Examples of the layer constitution that an organic EL device of the present embodiment can have are provided below:
a) anode/light-emitting layer/cathode
b) anode/hole injection layer/light-emitting layer/cathode
c) anode/hole injection layer/light-emitting layer/electron injection layer/cathode
e) anode/hole injection layer/light-emitting layer/electron transporting layer/cathode
f) anode/hole injection layer/light-emitting layer/electron transporting layer/electron injection layer/cathode
d) anode/hole transporting layer/light-emitting layer/cathode
e) anode/hole transporting layer/light-emitting layer/electron injection layer/cathode
f) anode/hole transporting layer/light-emitting layer/electron transporting layer/cathode
g) anode/hole transporting layer/light-emitting layer/electron transporting layer/electron injection layer/cathode
h) anode/hole injection layer/hole transporting layer/light-emitting layer/cathode
i) anode/hole injection layer/hole transporting layer/light-emitting layer/electron injection layer/cathode
j) anode/hole injection layer/hole transporting layer/light-emitting layer/electron transporting layer/cathode
k) anode/hole injection layer/hole transporting layer/light-emitting layer/electron transporting layer/electron injection layer/cathode
l) anode/light-emitting layer/electron injection layer/cathode
m) anode/light-emitting layer/electron transporting layer/cathode
n) anode/light-emitting layer/electron transporting layer/electron injection layer/cathode
   wherein, the sign "/" means that the layers sandwiching the sign "/" are layered next to each other, as the case hereinbelow.

An organic EL device of the present embodiment may have two or more light-emitting layers, and one example of an organic EL device having two light-emitting layers has a layer constitution represented in the following o) when a layered body sandwiched between the anode and the cathode in any one of the above layer constitutions a) through n) is expressed as "repeating unit A".
o) anode/(repeating unit A)/charge injection layer/(repeating unit A)/cathode
Moreover, one example of an organic EL device having three or more light-emitting layers has a layer constitution represented by the following p) when "(repeating unit A)/charge injection layer" is expressed as "repeating unit B".
p) anode/(repeating unit B)x/(repeating unit A)/cathode
Here, the sign "x" represents an integer of 2 or more, and the sign "(repeating unit B)x" represents a layered body in which x-folds repeating units B are layered.

The charge injection layer is a layer in which holes and electrons are generated by applying electric field. Examples of a charge generating layer include thin films made of vanadium oxide, indium tin oxide (Indium Tin Oxide: abbreviated as ITO), molybdenum oxide and the like.

In order to take out light emitted from the light-emitting layer, an organic EL device of the present embodiment usually has such a configuration that all layers of the device arranged on the side, with respect to the light-emitting layer, where the light is to be taken out are transparent. To describe an organic EL device having the layer constitution of substrate/anode/charge injection layer/hole transporting layer/light-emitting layer/electron transporting layer/charge injection layer/cathode/sealing member as one example, all of the substrate, the anode, the charge injection layer and the hole transporting layer are configured to be transparent in such a so-called bottom emission type organic EL device that light emitted from the light-emitting layer is taken out from the substrate side, whereas all of the electron transporting layer, the charge injection layer, the cathode and the sealing member are configured to be transparent in such a so-called top emission type organic EL device that light emitted from the light-emitting layer is taken out from the sealing member side. To describe an organic EL device having the layer constitution of substrate/cathode/charge injection layer/electron transporting layer/light-emitting layer/hole transporting layer/charge injection layer/anode/sealing member as one example, all of the substrate, the cathode, the charge injection layers and the electron transporting layer are configured to be transparent in a bottom emission type device, whereas all of the hole transporting layer, the charge injection layers, the cathode and the sealing member are configured to be transparent in a top emission type organic EL device. As to the degree of transparency, the visible light transmittance between the outermost surface of the organic EL device on the side where light is to be taken out and the light-emitting layer is preferably 40% or more. In the case of the organic EL device with which emission of light in the ultraviolet region or the infrared region is required, the device that exhibits light transmittance in this region of 40% or more is preferred.

An organic EL device of the present embodiment may further be provided with an insulating layer having a thickness of 2 nm or less next to the electrode in order to improve adhesiveness to the electrode or improve efficiency of charge injection from the electrode. For the purpose of improving adhesiveness or preventing mixing at an interface, it is permissible to insert a thin buffer layer between the aforementioned layers.

The order of the layers to be layered, the number of the layers and the thickness of each layer can be determined appropriately by taking into consideration the light emission efficiency and the duration life of the device.

### Specific constitution of organic EL device

Next, materials and formation methods of each of the layers constituting an organic EL device are explained more specifically.

### <Substrate>

As a substrate, materials that do not change during a process of producing an organic EL device are suitably used, and for example, glass, plastics, silicon substrates and their layered body are used. A commercially available product can be used as the substrate, or alternatively the substrate can be produced by a conventional method.

### <Anode>

As an anode, in the case of an organic EL device having such a constitution that light is taken out from a light-emitting layer through an anode, a transparent or translucent electrode is used. Thin films of metal oxides, metal sulfides, metals and the like that are high in electrical conductivity can be used as the transparent electrode or the translucent electrode, and materials that are high in light transmittance are suitably used. Specifically, films composed of indium oxide, zinc oxide, tin oxide, ITO, indium zinc oxide (Indium Zinc Oxide: abbreviated as IZO), gold, platinum, silver, copper and the like are used, and among these, thin films composed of ITO, IZO or tin oxide is suitably used. Examples of a method for producing the anode include a vacuum deposition method, a sputtering process, an ion plating method and a plating method. Moreover, an organic transparent conductive film of polyaniline or its derivatives, polythiophene or its derivatives or the like may also be used as the anode.

For the anode may also be used materials that reflect light, and metals, metal oxides and metal sulfides that have a work function of 3.0 eV or more are preferred as the materials.

The thickness of the anode can be determined appropriately by taking into consideration light permeability and electrical conductivity, and it is, for example, 10 nm to 10 µm, preferably 20 nm to 1 µm and more preferably 50 nm to 500 nm.

### <Hole injection layer>

Examples of the hole injection material to constitute the hole injection layer include oxides such as vanadium oxide, molybdenum oxide, ruthenium oxide and aluminum oxide, phenylamine-based compounds, starburst-type amine-based compounds, phthalocyanine-based compounds, amorphous carbon, polyaniline and polythiophene derivatives.

As a method for forming the hole injection layer may be, for example, film formation from a solution containing a hole injection material. The solvent to be used for the film formation from the solution is not particularly restricted as far as it is a solvent that dissolves the hole injection material; examples thereof include chlorine-containing solvents such as chloroform, methylene chloride and dichloroethane, ether solvents such as tetrahydrofuran, aromatic hydrocarbon solvents such as toluene and xylene, ketone solvents such as acetone and methyl ethyl ketone, ester solvents such as ethyl acetate, butyl acetate and ethyl cellosolve acetate, and water. When a material to form a hole injection layer is used as the aqueous macromolecular material in the above-described ink-jet ink for organic EL devices, a solution other than the aqueous macromolecular material in the above-described ink-jet ink for organic EL devices, is used as the solvent.

Examples of the method for forming a film from a solution include application methods such as a spin coating method, a casting method, a microgravure coating method, a gravure coating method, a bar coating method, a roll coating method, a wire bar coating method, a dip coating method, a spray coating method, a screen printing method, a flexographic printing method, an offset printing method and an ink jet printing method. When an ink-jet ink for organic EL devices of the present invention is used, the ink-jet printing method is used. Specifically, a hole injection layer can be formed by applying an ink-jet ink for organic EL devices using PEDOT/PSS as the aqueous macromolecular material by using an ink-jet apparatus.

As to the thickness of the hole injection layer, its optimal value varies depending on the material to be used, and the thickness is determined appropriately so that driving voltage and light-emitting efficiency may become appropriate values, and at least a thickness at which no pinholes are allowed to generate is required. An excessively large thickness raises the driving voltage of the device high, and is not preferable. Therefore, the thickness of the hole injection layer is, for example, 1 nm to 1 µm, preferably 2 nm to 500 nm and more preferably 5 nm to 200 nm.

### <Hole transporting layer>

Examples of the hole transporting material to constitute the hole transporting layer include polyvinylcarbazole or its derivatives, polysilane or its derivatives, polysiloxane derivatives having aromatic amine in their side chain or main chain, pyrazoline derivatives, arylamine derivatives, stilbene derivatives, triphenyldiamine derivatives, polyaniline or its derivatives, polythiophene or its derivatives, polyarylamine or its derivatives, polypyrrole or its derivatives, poly(p-phenylenevinylene) or its derivatives, or poly(2,5-thienylenevinylene) or its derivatives.

Among these, preferred as a hole transporting material are macromolecular hole transporting materials such as polyvinylcarbazole or its derivatives, polysilane or its derivatives, polysiloxane derivatives having an aromatic amine compound group in their side chain or main chain, polyaniline or its derivatives, polythiophene or its derivatives, polyarylamine or its derivatives, poly(p-phenylenevinylene) or its derivatives, or poly(2,5-thienylenevinylene) or its derivatives, and more preferred are polyvinylcarbazole or its derivatives, polysilane or its derivatives and polysiloxane derivatives having aromatic amine in their side chain or main chain. In the case of a low-molecular hole transporting material, it is preferred to use the material with the material dispersed in a macromolecular binder.

A method for forming the hole transporting layer, which is not particularly restricted, may be film formation from a mixed liquid containing a macromolecular binder and a hole transporting material in the case of low-molecular hole transporting materials, and may be film formation from a solution containing a hole transporting material in the case of macromolecular hole transporting materials.

The solvent to be used for the film formation from a solution is not particularly restricted as far as it is a solvent that dissolves the hole transporting material examples thereof include chlorine-containing solvents such as chloroform, methylene chloride and dichloroethane, ether solvents such as tetrahydrofuran, aromatic hydrocarbon solvents such as toluene and xylene, ketone solvents such as acetone and methyl ethyl ketone, ester solvents such as ethyl acetate, butyl acetate and ethyl cellosolve acetate. When a material to form a hole transporting layer is used as an aqueous macromolecular material in the above-described ink-jet ink for organic EL devices, a solution excluding the aqueous macromolecular material in the above-described ink-jet ink for organic EL devices, is used as the solvent.

The method for forming a film from a solution may be an application method similar to the method for forming the hole injection layer as described above.

As the macromolecular binder to be mixed, binders that do not excessively inhibit charge transportation are preferred, and binders that exhibit weak absorption to visible light are preferably used, and examples thereof include polycarbonate, polyacrylate, polymethyl acrylate, polymethyl methacrylate, polystyrene, polyvinyl chloride and polysiloxane.

As to the thickness of the hole transporting layer, its optimal value varies depending on the material to be used and the thickness is determined appropriately so that driving voltage and light emission efficiency may become appropriate values, and at least a thickness at which no pinholes are allowed to generate is required. An excessively large thickness raises the driving voltage of the device high, and is not preferable. Therefore, the thickness of the hole transporting layer is, for example, 1 nm to 1 µm, preferably 2 nm to 500 nm and more preferably 5 nm to 200 nm.

### <Light-emitting layer>

The light-emitting layer is usually formed mainly of an organic substance that emits fluorescence and/or phosphorescence, or of the organic substance and a dopant that assists this. The dopant is added, for example, for improving light emission efficiency or changing light emission wavelength. The organic substance may be either a low-molecular compound or a macromolecular compound, and the light-emitting layer preferably contains a macromolecular compound having a polystyrene-equivalent number average molecular weight of from 10³ to 10⁸. Examples of the light-emitting material to constitute the light-emitting layer include the following dye type materials, metal complex type materials, macromolecular type materials and dopant materials.

### (Dye type material)

Examples of the dye type materials include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, trifumanylamine derivatives, oxadiazole dimers, pyrazoline dimers, quinacridone derivatives and coumarin derivatives.

### (Metal complex type material)

Examples of the metal complex type materials include metal complexes having Al, Zn, Be or the like, or a rare earth metal such as Tb, Eu, or Dy, as a central metal, and an oxadiazole structure, a thiadiazole structure, a phenylpyridine structure, a phenylbenzimidazole structure, a quinoline structure or the like as a ligand. Examples thereof include metal complexes having light emission from a triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and europium complexes.

### (Macromolecule type material)

Examples of the macromolecule type materials include polyparaphenylene vinylene derivatives, polythiophene derivatives, polyparaphenylene derivatives, polysilane derivatives, polyacetylene derivatives, polyfluorene derivatives, polyvinylcarbazole derivatives and products produced by polymerizing the above-mentioned dye type materials or metal complex type light-emitting materials.

Among the above-mentioned light-emitting materials, examples of the material that emits blue light include distyrylarylene derivatives, oxadiazole derivatives, their polymers, polyvinylcarbazole derivatives, polyparaphenylene derivatives and polyfluorene derivatives. Among these, polyvinylcarbazole derivatives, polyparaphenylene derivatives and polyfluorene derivatives, which are macromolecular materials, are preferred.

Examples of the material that emits green light include quinacridone derivatives, coumarin derivatives, their polymers, polyparaphenylene vinylene derivatives and polyfluorene derivatives. Among these, polyparaphenylene vinylene derivatives and polyfluorene derivatives, which are macromolecular materials, are preferred.

Examples of the material that emits red light include coumarin derivatives, thiophene ring compounds, their polymers, polyparaphenylene vinylene derivatives, polythiophene derivatives and polyfluorene derivatives. Among these, polyparaphenylene vinylene derivatives, polythiophene derivatives and polyfluorene derivatives, which are macromolecular materials, are preferred.

### (Dopant material)

Examples of the dopant materials include perylene derivatives, coumarin derivatives, rubrene derivatives, quinacridone derivatives, squarium derivatives, porphyrin derivatives, styryl type dyes, tetracene derivatives, pyrazolone derivatives, decacyclene and phenoxazone. Thickness of such a light-emitting layer is usually about 2 nm to 200 nm.

### <Film forming method of light-emitting layer>

As a method for forming the light-emitting layer, a method of applying a solution containing a light-emitting material, a vacuum deposition method, a transferring method and the like can be used. Examples of the solvent to be used for the film formation from a solution include the same solvents as those to be used for forming the hole transporting layer from a solution as described above.

Examples of the method for applying a solution containing an light-emitting material include coating methods such as a spin coating method, a casting method, a microgravure coating method, a gravure coating method, a bar coating method, a roll coating method, a wire bar coating method, a dip coating method, a slit coating method, a capillary coating method, a spray coating method and a nozzle coating method, and applying methods such as a gravure printing method, a screen printing method, a flexographic printing method, an offset printing method, a reverse printing method and an ink jet printing method. Because it is easy to do pattern formation or multicolor application, preferred are printing methods such as a gravure printing method, a screen printing method, a flexographic printing method, an offset printing method, a reverse printing method and an ink jet printing method. In the case of a low-molecular compound that exhibits sublimability, a vacuum deposition method can be used. Moreover, a method of forming a light-emitting layer only in a desired position by laser transfer or thermal transfer can also be used. When an ink-jet ink for organic EL devices of the present invention using a light-emitting material as the aqueous macromolecular material is used as an application liquid, the ink-jet printing method is used.

### <Electron transporting layer>

Known materials can be used as the electron transporting material that constitute the electron transporting layer, and examples thereof include oxadiazole derivatives, anthraquinodimethane or its derivatives, benzoquinone or its derivatives, naphthoquinone or its derivatives, anthraquinone or its derivatives, tetracyanoanthraquinodimethane or its derivatives, fluorenone derivatives, diphenyldicyanoethylene or its derivatives, diphenoquinone derivatives, or 8-hydroxyquinoline or metal complexes of its derivatives, polyquinone or its derivatives, polyquinoxaline or its derivatives and polyfluorene or its derivative.

Preferred as an electron transporting material among these are oxadiazole derivatives, benzoquinone or its derivatives, anthraquinone or its derivatives, or 8-hydroxyquinoline or metal complexes of its derivatives, polyquinoline or its derivatives, polyquinoxaline or its derivatives and polyfluorene or its derivative, and 2-(4-biphenylyl)-5-(4-tert-butylphenyl)-1,3,4-oxadiazole, benzoquinone, anthraquinone, tris(8-quinolinol)aluminum and polyquinoline are more preferred.

A method for forming the electron transporting layer, which is not particularly restricted, may be a vacuum vapor deposition method from a powder or film formation from a solution or a molten state in the case of low-molecular electron transporting materials, and may be film formation from a solution or a molten state in the case of macromolecular electron transporting materials. When a film is formed from a solution or a molten state, a macromolecular binder may be used together. Examples of the method for forming an electron transporting layer from a solution include the same methods as the aforementioned methods for forming a hole transporting layer from a solution. When an ink-jet ink for organic EL devices of the present invention using an electron transporting material as the aqueous macromolecular material is used as an application liquid, the ink-jet printing method is used.

As to the thickness of the electron transporting layer, its optimal value varies depending on the material to be used and the thickness is determined appropriately so that driving voltage and light emission efficiency may become appropriate values, and at least a thickness at which no pinholes are allowed to generate is required. An excessively large thickness raises the driving voltage of the device becomes high, and is not preferable. Therefore, the thickness of the electron transporting layer is, for example, 1 nm to 1 µm, preferably 2 nm to 500 nm and more preferably 5 nm to 200 nm.

### <Electron injection layer>

An optimal material is selected appropriately as the material to constitute the electron injection layer depending on the kind of the light-emitting layer, and examples thereof include alkaline metals, alkaline earth metals, alloys containing one or more of alkaline metals or alkaline earth metals, and oxides, halides, carbonates of alkaline metals or alkaline earth metals, or mixtures of these substances. Examples of the alkaline metals, and the oxides, halides and carbonates of alkaline metals include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride and lithium carbonate. Examples of the alkaline earth metals, and the oxides, halides and carbonates of the alkaline earth metals include magnesium, calcium, barium, strontium, magnesium oxide, magnesium fluoride, calcium oxide, calcium fluoride, barium oxide, barium fluoride, strontium oxide, strontium fluoride and magnesium carbonate. The electron injection layer may be composed of a layered body in which two or more layers are layered and may be, for example, LiF/Ca. The electron injection layer is formed by a vacuum deposition method, a sputtering method, a printing method or the like. Thickness of the electron injection layer is preferably about 1 nm to about 1 µm.

### <Cathode>

The material of the cathode is preferably a material that has small work function, easily injects electrons into a light-emitting layer, and has high electrical conductivity. In the case of an organic EL device such that light is taken out from the anode side, the material of the cathode is preferably a material that is high in visible light reflectance in order to reflect the light from the light-emitting layer toward the anode by the cathode. For the cathode, there can be used, for example, alkaline metals, alkaline earth metals, transition metals and Group III-B metals. As the material of the cathode, there are used metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium, alloys of two or more of the foregoing metals, alloys of one or more of the foregoing metals and one or more selected from between gold, silver, platinum, copper, manganese, titanium, cobalt, nickel, tungsten and tin, or graphite or graphite intercalation compounds and the like. Examples of the alloys include magnesium-silver alloy, magnesium-indium alloy, magnesium-aluminum alloy, indium-silver alloy, lithium-aluminum alloy, lithium-magnesium alloy, lithium-indium alloy and calcium-aluminum alloy. Transparent conductive electrodes composed of conductive metal oxides, conductive organic substances and the like can be used as a cathode. Specifically, examples of the conductive metal oxides include indium oxide, zinc oxide, tin oxide, ITO and IZO, and examples of the conductive organic substances include polyaniline or its derivatives, and polythiophene or its derivatives. The cathode may be composed of a layered body in which two or more layers are layered. Moreover, an electron injection layer may also be used as the cathode.

The thickness of the cathode is determined appropriately by taking into consideration electrical conductivity and durability, and it is, for example, 10 nm to 10 µm, preferably 20 nm to 1 µm and more preferably 50 nm to 500 nm.

Examples of a method for producing the cathode include a vacuum deposition method, a sputtering method and a layering method by which a metal thin film is bonded by thermocompression.

### <Insulating layer>

Examples of the material of the insulating layer include metal fluorides, metal oxides and organic insulating materials. Examples of an organic EL device in which an insulating layer having a thickness of 2 nm or less is provided include one in which an insulating layer having a thickness of 2 nm or less is provided next to the cathode, and one in which an insulating layer having a thickness of 2 nm or less is provided next to the anode.

The organic EL device explained above can be used suitably for planar light sources to be used as light sources of curved or flat illumination apparatuses such as scanners, and for display apparatuses.

Examples of display apparatuses having organic EL devices include segment display apparatuses and dot matrix display apparatuses. The dot matrix display apparatuses include active matrix display apparatuses and passive matrix display apparatuses. Organic EL devices are used as light emitting devices that constitute individual pixels in active matrix display apparatuses and passive matrix display apparatuses. Moreover, organic EL devices are used as light-emitting devices that constitute individual segments in segment display apparatuses and also used as back light in liquid crystal display apparatuses.

An ink-jet ink that includes water, a surfactant and an aqueous macromolecular material, has a static surface tension of 40 mN/m or less, and has a dynamic surface tension, measured by a maximum bubble pressure method at 100 Hz, of 55 mN/m or more can be used suitably also for the production of organic transistors and organic solar batteries.

### EXAMPLES

### Preparation Example 1

Ink 1 was prepared by mixing a PEDOT/PSS aqueous solution (commercial name: Clevious P VP CH8000, produced by H.C. Stark) and glycerin in a weight ratio of 70 : 30.

### Example 1

A PEGDE aqueous solution was prepared by mixing pentaethylene glycol monododecyl ether and water in a weight ratio of 5 : 95. Subsequently, ink 2 was prepared by mixing the PEDOT/PSS aqueous solution (commercial name: Clevious P VP CH8000, produced by H.C. Stark), glycerin and the PEGDE aqueous solution in a weight ratio of 70 : 29 : 1.

### Preparation Example 2

Ink 3 was prepared by mixing the PEDOT/PSS aqueous solution (commercial name: Clevious P VP CH8000, produced by H.C. Stark), the PEGDE aqueous solution, glycerin and a Surfynol solution containing a surfactant having acetylene group (commercial name: Surfynol 104PA, produced by Nissin Chemical Industry Co., Ltd., a solution prepared by mixing Surfynol 104 and isopropanol in a weight ratio of 50: 50) in a weight ratio of 70 : 29 : 1.

### Measurement of static surface tension

The static surface tensions of inks 1 to 3 were measured by the pendant drop method using a contact angle measurement device (commercial name: OCA30, manufactured by Data Physics Corporation). The static surface tension of ink 1 was 69.6 mN/m, that of ink 2 was 31.4 mN/m, and that of ink 3 was 32.1 mN/m.

### Measurement of dynamic surface tension

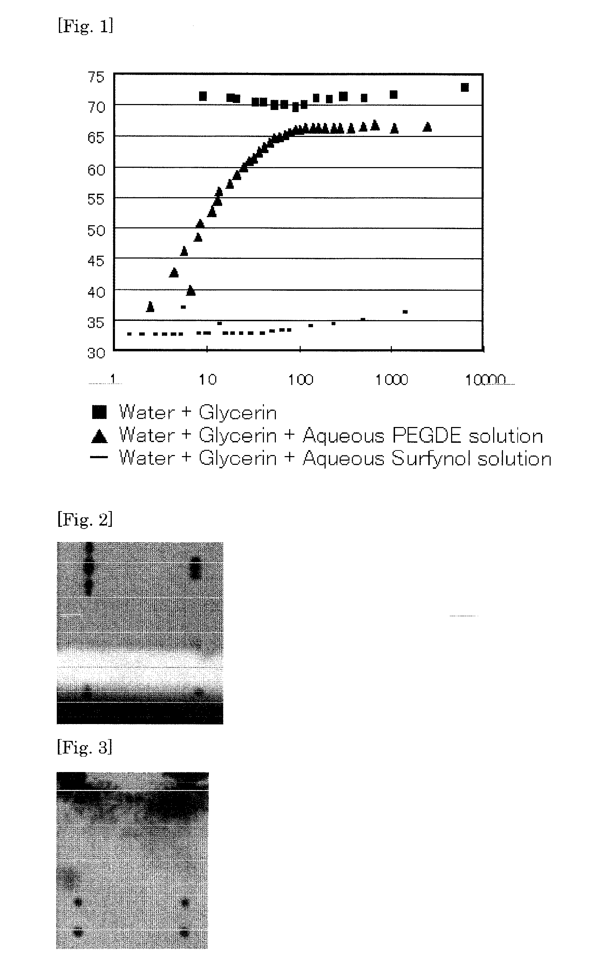

The dynamic surface tensions of inks 1 to 3 were measured using a dynamic surface tension measurement device (commercial name: Bubble Pressure Tensiometer MPT2, manufactured by LAUDA) with the bubble discharge frequency being changed. The results are shown in Fig. 1. Ink 2 had a static surface tension of 40 mN/m or less and, as shown in Fig. 1, a dynamic surface tension at 100 Hz of 55 mN/m or more.

### Example 2

Next, ink 2 was dropped through a nozzle using an ink-jet apparatus (manufactured by Dimatix, Model DMP-2831) and a droplet was observed with a built-in camera. At the time of dropping the ink, a voltage of 25 V was applied to a piezoelectric element and the frequency was 1000 Hz. Fig. 3 shows a situation of dropping of ink 2. When ink 2 was jetted onto a substrate, the ink 2 wet-spread.

### Comparative Example 1

Ink was dropped by the same method as that used in Example 2 except that ink 1 was used instead of ink 2. Fig. 2 illustrates a situation of dropping ink 1. When ink 1 was jetted onto a substrate, the ink 1 failed to wet-spread.

### Comparative Example 2

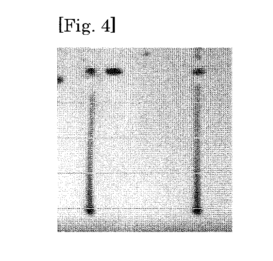

Ink was dropped by the same method as that used in Example 2 except that ink 3 was used instead of ink 2. Fig. 4 illustrates a situation of dropping ink 3.

In Figs. 2 through 4, the upper side is the vertically upper side, and the lower side is the vertically lower side. Two nozzles are seen one on the left and the other on the right of the upper side, and a state in which ink is being jetted downward through the two nozzles is shown. In Fig. 2 and Fig. 3, droplets have been dropped normally, whereas in Fig. 4, ligaments have been trailed. Inks 1 and 2, which are high in dynamic surface tension, are suitable for dropping desired droplets, whereas as to ink 3, which is low in dynamic surface tension, desired droplets cannot be dropped due to trailing a ligament. It is noted that ink 1 trails no ligaments, but it fails to wet-spread on a hit surface because of its high static surface tension, whereas ink 2, which is lower in static surface tension, wet-spreads on a hit surface.

### Example 3

A pattern of an ITO electrode, which is an anode, is formed on a glass substrate, and a pank is formed thereon by patterning a pank material. After rinsing the substrate, an O₂ plasma treatment is performed on the surface of the substrate, followed by a CF₄ plasma treatment. Then, a hole injection layer is formed by dropping ink 2 through a nozzle into a region surrounded by the pank by using an ink-jet apparatus (manufactured by Dimatix, Model DMP-2831). Then, a light-emitting layer is formed by applying a solution containing a light-emitting material and a solvent onto the hole injection layer. Barium is vapor-deposited on the light-emitting layer, and aluminum is vapor-deposited thereon. Then, an organic EL device can be produced by performing glass sealing.

## Claims

1. An ink-jet ink for organic electroluminescent devices comprising water, a surfactant and an aqueous macromolecular material, wherein the ink has a static surface tension of 40 mN/m or less and a dynamic surface tension, measured by the maximum bubble pressure method at 100 Hz, of 55 mN/m or more.

2. The ink-jet ink for organic electroluminescent devices according to claim 1, wherein the surfactant comprises a linear polyether alcohol.

3. The ink-jet ink for organic electroluminescent devices according to claim 1 or 2, wherein the molecular weight of the linear polyether alcohol is 100 to 800.

4. The ink-jet ink for organic electroluminescent devices according to claim 2 or 3, wherein the linear polyether alcohol has a structure represented by the formula:
R₁-(O-R₂)ₙ-OH [Chem 1]
wherein R₁ is an alkyl group that may have a substituent, R₂ is an alkylene group that may have a substituent, and n is a natural number, provided that when there are two or more R₂s, the R₂s may be the same or different.

5. The ink-jet ink for organic electroluminescent devices according to claim 4, wherein R₁ is a linear alkyl group having 4 to 20 carbon atoms, R₂ is a linear alkylene group having 1 to 10 carbon atoms, and n is an integer of 1 to 12.

6. The ink-jet ink for organic electroluminescent devices according to claim 1, wherein the surfactant is pentaethylene glycol monododecyl ether.

7. The ink-jet ink for organic electroluminescent devices according to claim 1, wherein the content of the surfactant is 0.001 to 10 parts by weight based on 100 parts by weight of the whole amount of the ink-jet ink for organic electroluminescent devices.

8. The ink-jet ink for organic electroluminescent devices according to any one of claims 1 to 7, wherein the aqueous macromolecular material is an aqueous conductive macromolecule.

9. A method for producing an organic electroluminescent device having a pair of electrodes and an organic layer provided between the electrodes, wherein the method for producing an organic electroluminescent device comprises a step of forming the organic layer by the ink-jet method using the ink-jet ink for organic electroluminescent devices according to any one of claims 1 to 8.
